# EUROPÄISCHE PATENTSCHRIFT

(11) **EP 1 493 176 B1**
(45) Veröffentlichungstag und Bekanntmachung des Hinweises auf die Patenterteilung: **06.07.2005**
(21) Anmeldenummer: 03720395.7
(22) Anmeldetag: 31.03.2003
(51) Int. Cl.: H01L 21/00, H01L 21/68

(54) **VORRICHTUNG ZUR AUFNAHME VON SUBSTRATEN**
DEVICE FOR ACCOMMODATING SUBSTRATES
DISPOSITIF POUR LOGER DES SUBSTRATS

(30) Priorität: 05.04.2002 DE 10215283
(43) Veröffentlichungstag der Anmeldung: 05.01.2005
(73) Patentinhaber: ASTEC Halbleitertechnologie GmbH, 92348 Berg (DE)
(72) Erfinder: NIESE, Matthias, 92318 Neumarkt (DE); FRANZKE, Jörg, 92318 Neumarkt (DE); SCHWECKENDIEK, Jürgen, 10967 Berlin (DE)
(74) Vertreter: Gassner, Wolfgang, Dr.
(86) Internationale Anmeldenummer: PCT/EP2003/003312
(87) Internationale Veröffentlichungsnummer: WO 2003/085704

(56) Entgegenhaltungen:
- WO-A-96/05611
- DE-A- 2 422 527
- DE-A- 4 300 205
- DE-A- 19 753 471
- US-A- 5 944 038

## Beschreibung

Die Erfindung betrifft eine Vorrichtung zur Aufnahme von Substraten nach dem Oberbegriff des Anspruchs 1.

Eine derartige Vorrichtung dient zum senkrechten bzw. vertikalen Einstellen einer Vielzahl von Substraten, wie Wafern oder Substraten zur Herstellung photovoltaischer Elemente. Die Vorrichtung wird mit den darin aufgenommenen Substraten zum Ätzen, Reinigen oder zum Trocknen in Behandlungsbäder getaucht und anschließend daraus wieder herausgehoben.

Nach dem Stand der Technik bestehen solche Vorrichtungen, die auch als Horden oder Carrier bezeichnet werden, üblicherweise aus vier umlaufenden Wänden. An der Innenseite der einander gegenüberliegenden Längswände befinden sich vertikal verlaufende Schlitze, in welche die Substrate randlich eingesteckt werden. Die Längswände können im Bereich ihrer Unterkanten nach innen hin umgebogen sein, damit die Substrate nach unten nicht herausfallen. Eine derartige Vorrichtung ist z. B. aus der US 5,299,901 bekannt. Ähnliche Vorrichtungen sind in der EP 0 385 536, der US 4,963,069 sowie der US 4,722,752 beschrieben.

Eine gattungsgemäße Vorrichtung ist z. B. aus der DE 42 23 326 B1 sowie der DE 44 28 169 C2 bekannt. Dabei werden die Substrate auf mehreren stabartigen Trägerelementen abgestützt, welche zwei aneinander gegenüberliegende Wände miteinander verbinden. Längswände mit darin vorgesehenen Schlitzen weisen diese Vorrichtungen nicht auf.

In der Praxis kommt es mitunter vor, dass in einem Ätzbad beim Ätzvorgang gebildeter Wasserstoff in Form von Blasen an der Oberfläche der Substrate anhaftet. Die Substrate können infolgedessen aus der Vorrichtung herausgehoben werden und im Ätzbad aufschwimmen. Das Entfernen solcher aufschwimmender Substrate erfordert einen zusätzlichen Aufwand. Es kann dabei zu unerwünschten Kontaminationen der Behandlungsflüssigkeiten kommen.

Aus der DE 43 00 205 A1 ist eine Kassette zur Aufnahme von Substraten bekannt. Die Kassette weist einen Einsatz auf, in dem die Substrate auf zwei Trägerelementen abgestützt sind. Zur Arretierung der Substrate ist ein Trägergegenelement vorgesehen. Mit der vorgeschlagenen Kassette wird ein Aufschwimmen der Substrate im Ätzbad verhindert. Das Be- oder Entladen der Substrate ist allerdings zeitaufwändig. Es muss zunächst der Einsatz aus der Kassette gehoben und anschließend das Trägergegenelement entfernt werden.

Aufgabe der Erfindung ist es, die Nachteile nach dem Stand der Technik zu beseitigen. Es soll insbesondere eine Vorrichtung angegeben werden, mit der ein Aufschwimmen von Substraten verhindert werden kann und die möglichst einfach handhabbar ist.

Diese Aufgabe wird durch die Merkmale des Anspruchs 1 gelöst. Zweckmäßige Ausgestaltungen ergeben sich aus den Merkmalen der Ansprüche 2 bis 25.

Nach Maßgabe der Erfindung ist vorgesehen, dass mindestens ein die beiden Wände verbindendes Trägergegenelement vorgesehen ist, welches bezüglich der Trägerelemente so angeordnet ist, dass damit eine Vertikalbewegung der Substrate relativ zu den Wänden begrenzt und ein Be- oder Entladen der Substrate schräg bezüglich der Vertikalrichtung ermöglicht wird.

Damit wird auf einfache Weise erreicht, dass die Substrate im Behandlungsbad nicht aus der Vorrichtung gehoben werden. Eine zur Flüssigkeitsoberfläche gerichtete Vertikalbewegung der Substrate wird durch das Trägergegenelement begrenzt. D.h. ein Abheben der Substrate von den Trägerelementen ist nur so weit möglich, dass sie noch sicher in den Haltemitteln gehalten und ein Entweichen aus der Vorrichtung unmöglich ist. Die Vorrichtung ist üblicherweise so ausgeführt, dass die Substrate im untergetauchten Zustand um wenige Millimeter von den Trägerelementen abheben können. Auch bei einer schräg nach oben zur Flüssigkeitsoberfläche gerichteten Bewegung der Substrate im Behandlungsbad können diese aus der Vorrichtung nicht entweichen, weil sie in diesem Fall an der Wand des Behandlungsbeckens anstoßen würden. Dagegen können die Substrate bei aus dem Behandlungsbad herausgehobener Vorrichtung schräg be- oder entladen werden. Es ist insbesondere nicht erforderlich, zum Be- oder Entladen das Trägergegenelement von der Vorrichtung zu entfernen.

Unter einem "stabartigen Trägerelement" wird allgemein ein langgestrecktes Trägerelement verstanden. Der Querschnitt eines solchen Trägerelements kann rund, rechteckig, polygonal oder auch andere Formen annehmen. Wesentlich für die Ausgestaltung der Trägerelemente ist, dass beim Herausheben der Vorrichtung aus dem Behandlungsbad daran haftende Behandlungsflüssigkeit vollständig und ungehindert abfließt.

Das Trägergegenelement kann an den Wänden, vorzugsweise lösbar, befestigt sein. Bei einer lösbaren Befestigung des Trägergegenelements kann das Trägergegenelement nach dem Herausheben der Vorrichtung aus dem Behandlungsbad entfernt und nachfolgend können die Substrate auch in vertikaler Richtung be- oder entladen werden. Eine lösbare Befestigung kann beispielsweise mittels einer geeigneten Rastvorrichtung realisiert werden, die so ausgebildet ist, dass das Trägergegenelement mit einem Roboter gelöst und nachfolgend wieder befestigt werden kann. Die vorgeschlagene Vorrichtung ist besonders universell.

Nach einer Ausgestaltung weist zumindest eines der Trägerelemente als Haltemittel schlitzartige Ausnehmungen oder Zähne auf. Das Trägerelement kann z. B. ein zylindrischer Stab sein, der als Haltemittel nebeneinander liegende Einschnitte aufweist. Es kann aber auch sein, dass auf dem Stab sägezahnartig Zähne nebeneinander vorgesehen sind.

Die Zähne sind zweckmäßigerweise so auf dem Trägerelement angebracht, dass ein Zahngrund der Zähne auf einer oberen Scheitellinie des Trägerelements liegt. Dadurch wird sichergestellt, dass bei einem Herausheben eines mit solchen Zähnen versehenen Trägerelements die Behandlungsflüssigkeit vollständig davon abfließt.

In ähnlicher Weise kann auch das Trägergegenelement in Richtung des Trägerelements weisende als schlitzartige Ausnehmungen oder Zähne ausgebildete Haltemittel aufweisen. Die Zähne sind auf dem Trägergegenelement zweckmäßigerweise so angebracht, dass ein Zahngrund der Zähne auf der unteren Scheitellinie des Trägergegenelements liegt. Diese Maßnahme gewährleistet ebenfalls ein vollständiges sicheres Ablaufen von Behandlungsflüssigkeit beim Herausheben des Trägergegenelements aus dem Behandlungsbad.

Nach einer weiteren besonders vorteilhaften Ausgestaltung ist das Trägergegenelement bezüglich des Trägerelements so angeordnet oder ausgebildet, dass die Substrate bei einer Bewegung in die Vertikalrichtung stets in den Haltemitteln gehalten werden. In diesem Fall wird in der Behandlungsflüssigkeit nicht nur ein unerwünschtes Herausheben der Substrate aus der Vorrichtung vermieden, sondern es wird auch sichergestellt, dass die Substrate voneinander beabstandet parallel in der Vorrichtung gehalten werden. Eine Vertikalbewegung der Substrate in einem vorgegebenen begrenzten Maß innerhalb der Halteelemente ermöglicht während des Ätzens auch einen Flüssigkeitsaustausch und damit einen Ätzabtrag im Bereich der Auflagepunkte der Substrate und damit also ein vollflächiges Ätzen der Substrate. Abgesehen davon ermöglicht ein geringfügiges Abheben der Substrate in Vertikalrichtung ein vollständiges Trocknen der Substrate. Mittels einer geeigneten Vorrichtung können dazu die Substrate langsam aus dem Behandlungsbad herausgehoben werden. Während des Durchtritts der Substrate durch die Oberfläche der Behandlungsflüssigkeit können diese von den Trägerelementen kurzzeitig abgehoben und nach dem Durchtritt der Trägerelemente durch die Behandlungsflüssigkeit wieder auf diese aufgesetzt werden.

Zweckmäßigerweise weist das Trägerelement einen im Wesentlichen vertikal nach unten sich erstreckenden Ablaufsteg auf. In ähnlicher Weise kann das Trägergegenelement einen im Wesentlichen vertikal nach oben sich erstreckenden weiteren Ablaufsteg aufweisen. Eine Breite des Ablaufstegs und/oder des weiteren Ablaufstegs kann zur Mitte des Trägerelements bzw. des Trägergegenelements hin zunehmen. Das Vorsehen eines derartigen Ablaufstegs und weiteren Ablaufstegs trägt dazu bei, dass beim Herausheben des Trägerelements bzw. des Trägergegenelements aus der Behandlungsflüssigkeit diese vollständig vom Trägerelement bzw. Trägergegenelement abläuft. Es ist sichergestellt, dass das Trägerelement bzw. das Trägergegenelement vollständig trocken aus der Behandlungsflüssigkeit herausgehoben werden können.

Die Kanten der Wände können abgeschrägt sein. Des Weiteren ist es zweckmäßig, dass die Unterkanten der Wände beiderseits einer mittig angeordneten U-förmigen ersten Ausnehmung schräg abfallen. Die U-förmige erste Ausnehmung dient als Zentriermittel zum Einsetzen der Vorrichtung in eine korrespondierende Haltevorrichtung im Bewegungsbecken. Die vorgeschlagene Ausbildung der Kanten sowie der Unterkanten trägt dazu bei, dass die Behandlungsflüssigkeit vollständig von den Wänden beim Herausheben der Vorrichtung abläuft.

Nach einer weiteren Ausgestaltung weisen die Seitenkanten der Wände in einem oberen Abschnitt in einander gegenüberliegender Anordnung zweite Ausnehmungen zum Eingriff einer Greifvorrichtung auf. Des Weiteren kann eine Oberkante der Wände eine dritte Ausnehmung zum Eingreifen einer Be- bzw. Entladevorrichtung für Substrate aufweist. Die dritte Ausnehmung wird zweckmäßigerweise durch wenigstens zwei schräg zu den Seitenkanten verlaufende Ausnehmungskanten begrenzt.

Nach einer weiteren Ausgestaltung ist vorgesehen, dass ein wesentlicher Abschnitt der Seitenkanten der Wände vertikal verläuft. Die vertikale Ausrichtung der Seitenkanten entspricht der vertikalen Bewegungsrichtung der Vorrichtung im Bewegungsbad. Durch die vertikale Ausbildung der Seitenkanten ist ein problemloses Ablaufen daran anhaftender Behandlungsflüssigkeit beim Herausheben der Vorrichtung, aus der Behandlungsflüssigkeit gewährleistet.

Nach einer weiteren Ausgestaltung sind das Trägerelement und/oder das Trägergegenelement aus einer, vorzugsweise mit einem ersten Kunststoff ummantelten, Versteifungsstruktur gebildet. Die Versteifungsstruktur kann aus Metall, Glas, Keramik oder einem, vorzugsweise mit Fasern verstärkten, zweiten Kunststoff hergestellt sein. Die Versteifungsstruktur kann beispielsweise aus einer Siliziumkarbid-Keramik oder aus Quarzglas hergestellt sein. Die Wände können ebenfalls aus dem ersten Kunststoff hergestellt sein. Dabei handelt es sich vorzugsweise um einen gegen Säuren und Basen resistenten Kunststoff, der aus der folgenden Gruppe ausgewählt sein kann: PFA (Perfluor-Alkoxy-Polymer), PTFE (Polyvinyldienedifluorid), PVDF (Polytetrafluorethylen), PP (Polypropylen).

Auch der erste Kunststoff kann mit Fasern verstärkt sein. Als Fasern eignen sich insbesondere aus Kohle oder Glas hergestellte Fasern.

Nach einer besonderen Ausgestaltung ist vorgesehen, dass vier Trägerelemente die Wände verbinden. Die Trägerelemente sind üblicherweise parallel angeordnet. Deren Haltemittel weisen etwa in Richtung einer parallel zu den Trägerelementen verlaufenden gedachten zentralen Achse der Vorrichtung. Es können zwei untere Trägerelemente in der Nähe einer Unterkante der Wände und zwei obere Trägerelemente in der Nähe eines unteren Abschnitts der Seitenkanten der Wände angebracht sein.

Das Trägergegenelement kann in der Nähe einer Oberkante der Seitenwände angebracht sein. Das Trägergegenelement ist zweckmäßigerweise bezüglich einer die Anordnung oder die Ausbildung des/der Trägerelement/Trägerelemente betreffenden und parallel zu dieser/diesen verlaufenden Symmetrieebene versetzt angeordnet. Durch diese besondere Anordnung wird eine Vertikalbewegung der Substrate im Behandlungsbad unterbunden. Gleichzeitig wird ein schräges Be- oder Entladen der Substrate außerhalb des Behandlungsbads gewährleistet. Das mindestens eine Trägergegenelement kann fest mit den Wänden verbunden sein. Es kann aber auch lösbar an den Wänden z. B. mittels einer Schraub-, Klemm- oder Rastverbindung befestigt sein.

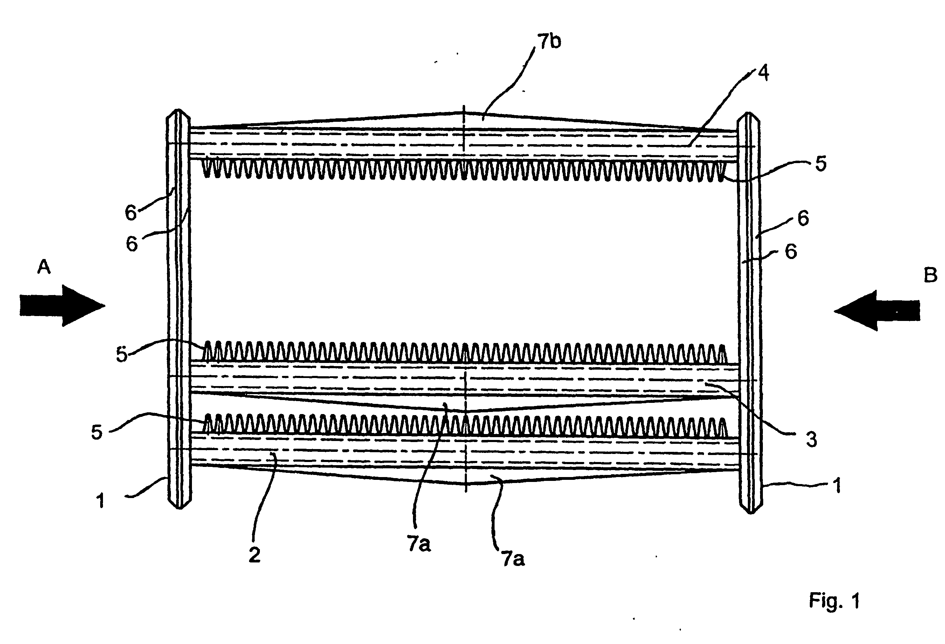

Nachfolgend wird ein Ausführungsbeispiel der Erfindung näher erläutert. Hier zeigen
- Fig. 1: eine Ansicht auf die Längsseite einer Vorrichtung,
- Fig. 2: die Ansicht A gemäß Fig. 1,
- Fig. 3: die Ansicht B gemäß Fig. 1 und
- Fig. 4: eine schematische Querschnittsansicht eines Trägerelements bzw. eines Trägergegenelements.

In den Figuren ist eine Vorrichtung zur Aufnahme von Substraten und dgl. in verschiedenen Ansichten gezeigt. Zwei Wände 1 sind unlösbar verbunden mit zwei unteren Trägerelementen 2, zwei oberen Trägerelementen 3 sowie einem Trägergegenelement 4. Die unteren 2 und/oder oberen Trägerelemente 3 sind bezüglich einer Symmetrieebene E symmetrisch angeordnet. Das Trägergegenelement 4 ist bezüglich der Symmetrieebene E versetzt angeordnet. Es ist hier ebenfalls unlösbar mit den Wänden 1 verbunden. Selbstverständlich ist es auch möglich, dass das Trägergegenelement 4 lösbar mit den Wänden 1 verbunden ist. Dazu kann das Trägergegenelement 4 beispielsweise mit herkömmlichen Rastverbindungen an den Wänden 1 befestigt werden.

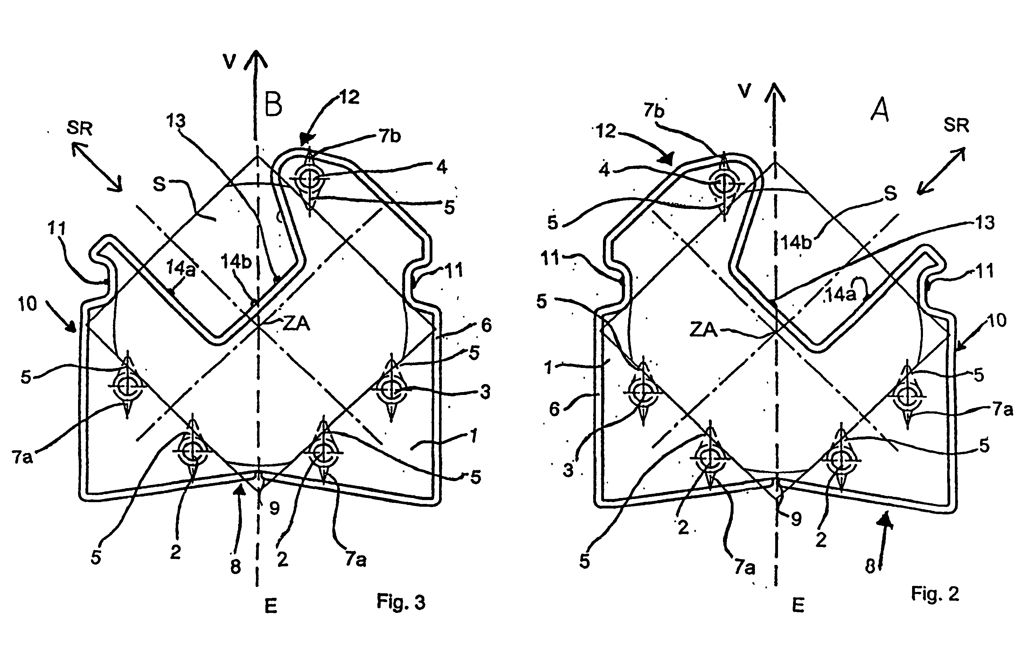

Wie insbesondere aus den Fig. 2 und 3 ersichtlich ist, sind die Wände 1 spiegelbildlich ausgebildet. Ein in der Vorrichtung aufgenommenes Substrat ist mit S bezeichnet. Das Substrat S ist abgestützt auf den unteren 2 und den oberen Trägerelementen 3. Eine Bewegung des Substrats S in eine mit V bezeichnete Vertikalrichtung wird durch das Trägergegenelement 4 begrenzt. Dagegen ist ein Be- bzw. Entladen der Vorrichtung in einer mit SR bezeichneten Schrägrichtung möglich.

Sofern das Trägergegenelement 4 lösbar an den Wänden 1 angebracht ist, ist es auch möglich, nach einem Entfernen des Trägergegenelements 4 die Substrate S in Vertikalrichtung zu be- und entladen.

Auf den Trägerelementen 2, 3 sind als Haltemittel Zähne 5 vorgesehen. Die Zähne 5 sind hier vertikal nach oben angeordnet. Es ist aber auch möglich, dass die Zähne 5 in Richtung in einer mit ZA bezeichneten Zentralachse weisen. Die an den Trägergegenelementen 4 vorgesehenen Zähne 5 weisen vertikal nach unten. Auch hier ist es möglich, dass die Zähne 5 in Richtung der Zentralachse ZA weisen. Ein durch zwei nebeneinander liegende Zähne 5 gebildeter Schlitz verjüngt sich in Richtung des Trägerelements 2, 3 bzw. des Trägerelements 4.

Die an den Wänden 1 befindlichen umlaufenden Kanten sind mit Abschrägungen 6 versehen.

Die Trägerelemente 2, 3 weisen jeweils vertikal nach unten sich erstreckende Ablaufstege 7a, das Trägergegenelement 4 einen sich vertikal nach oben erstreckenden weiteren Ablaufsteg 7b auf. Eine Breite bzw. Höhe der Ablaufstege 7a, 7b Unterkanten 8 der Wände 1 weisen mittig eine U-förmige erste Ausnehmung 9 auf. Die Unterkanten 8 fallen beiderseits der U-förmigen ersten Ausnehmung 9 nach außen hin ab.

Seitenkanten 10 verlaufen im Wesentlichen vertikal, d.h. parallel zur Vertikalrichtung V. Sie weisen in einem oberen Abschnitt zweite Ausnehmungen 11 zum Eingriff einer (hier nicht gezeigten) Greifeinrichtung zum Greifen der Vorrichtung auf.

An einer Oberkante 12 der Wände 1 ist außerdem eine dritte Ausnehmung 13. Die dritte Ausnehmung 13 ermöglicht das Eingreifen eines Greifarms zum Be- und Entladen der Vorrichtung mit Substraten S. Mindestens zwei der die dritte Ausnehmung begrenzenden Ausnehmungskanten 14a, 14b verlaufen schräg zu den Seitenkanten 10. Die so gebildete schräge dritte Ausnehmung 13 ermöglicht ein Be- und Entladen der Vorrichtung mit Substraten S in der Schrägrichtung SR.

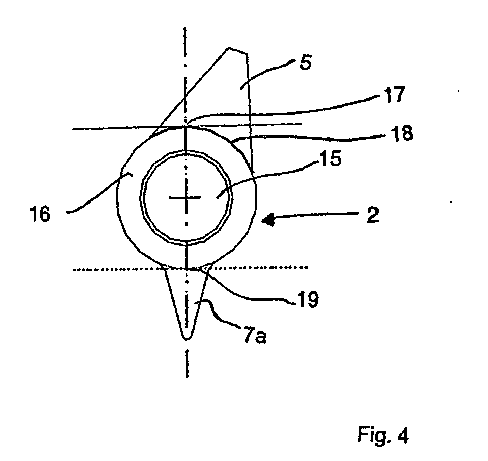

In Fig. 4 ist ein Querschnitt durch ein unteres Trägerelement 2 gezeigt. Das untere Trägerelement 2 ist gebildet aus einer zentralen Versteifungsstruktur 15, die zweckmäßigerweise aus einem mit Kohlefaser verstärkten zweiten Kunststoff hergestellt ist. Selbstverständlich kann die Versteifungsstruktur auch aus anderen Materialien hergestellt sein, wobei nichtmetallische Materialien bevorzugt sind. Die Versteifungsstruktur 15 weist eine aus einem ersten Kunststoff hergestellte Ummantelung 16 auf. Der erste Kunststoff ist zweckmäßigerweise resistent gegen Säuren und Basen. Es kann sich dabei beispielsweise handeln um PFA (Perfluor-Alkoxy-Polymer), PTFE (Polyvinyldienedifluorid), PVDF (Polytetrafluorethylen), PP (Polypropylen).

Die Zähne 5 und die Ablaufstege 7a, 7b sind zweckmäßigerweise in einstückiger Ausbildung mit der Ummantelung 16 hergestellt. Mit 17 ist ein oberer Scheitelpunkt des hier zylindrisch ausgebildeten unteren Trägerelements 2 bezeichnet. Ein Zahngrund 18 ist im Querschnitt die hier kreissegmentförmige ausgebildete Kontaktlinie zwischen dem Zahn 5 und dem unteren Trägerelement 2. Damit stets ein vollständiger Ablauf von Reinigungsflüssigkeit gewährleistet ist, sind die Zähne 5 so anzuordnen, dass der obere Scheitelpunkt 17 Bestandteil des Zahngrunds 18 ist.

Die gezeigte Anordnungen der Zähne 5 gilt in gleicher Weise für die oberen Trägerelemente 3. Sie gilt in analoger Weise für das Trägergegenelement 4, wobei hier bezüglich der Anordnung der Zähne 5 auf einem unteren Scheitelpunkt abzustellen ist, der in Fig. 4 mit dem Bezugszeichen 19 angedeutet ist.

Im Rahmen der vorliegenden Erfindung ist es selbstverständlich möglich, die Anzahl und Ausbildung der Trägerelemente 2, 3 sowie des Trägergegenelements 4 zu ändern, insbesondere an die Geometrie des jeweils zu transportierenden Substrats S anzupassen. So ist es beispielsweise auch möglich, statt der im vorliegenden Ausführungsbeispiel beschriebenen vier Trägerelemente nur zwei oder ein Trägerelement/e zu verwenden.

Mit der vorliegenden Erfindung wird auf einfache Weise eine unerwünschte Vertikalbewegung von Substraten S in einem Behandlungsbad unterbunden. Gleichzeitig ist ein einfaches Be- und Entladen der Vorrichtung möglich, ohne dass dazu ein Niederhalteelement, wie das Trägergegenelement 4, von der Vorrichtung entfernt werden muss.

### Bezugszeichenliste

- 1: Wand
- 2: unteres Trägerelement
- 3: oberes Trägerelement
- 4: Trägergegenelement
- 5: Zahn
- 6: Abschrägung
- 7a,b: Ablaufsteg
- 8: Unterkante
- 9: erste Ausnehmung
- 10: Seitenkante
- 11: zweite Ausnehmung
- 12: Oberkante
- 13: dritte Ausnehmung
- 14a,b: Ausnehmungskanten
- 15: Versteifungsstruktur
- 16: Ummantelung
- 17: oberer Scheitelpunkt
- 18: Zahngrund
- 19: unterer Scheitelpunkt

- V: Vertikalrichtung
- SR: Schrägrichtung
- S: Substrat
- E: Symmetrieebene
- ZA: Zentralachse

## Patentansprüche

1. Vorrichtung zur Aufnahme von Substraten (S), insbesondere Wafern oder Siliziumsubstraten zur Herstellung photovoltaischer Elemente, mit zwei einander gegenüberliegenden Wänden (1),
wobei mindestens zwei die Wände (1) verbindende stabartige Trägerelemente (2, 3) vorgesehen sind,
wobei die Trägerelemente (2, 3) zum Halten darauf abgestützter Substrate (S) in einer vertikalen, parallel zu den Wänden (1) orientierten Stellung mit Haltemitteln (5) versehen ist,
**dadurch gekennzeichnet, dass**
mindestens ein, die beiden Wände (1) verbindendes stabartiges Trägergegenelement (4) vorgesehen ist, welches bezüglich der Trägerelemente (2, 3) so angeordnet ist,
dass damit eine Vertikalbewegung der Substrate (S) relativ zu den Wänden (1) begrenzt und ein Be- oder Entladen der Substrate (S) schräg bezüglich der Vertikalrichtung (V) ermöglicht wird.

2. Vorrichtung nach Anspruch 1, wobei das Trägergegenelement (4) an den Wänden (1), vorzugsweise lösbar, befestigt ist.

3. Vorrichtung nach Anspruch 1 oder 2, wobei die Substrate (S) bei entferntem Trägergegenelement (4) außerdem in Vertikalrichtung (V) be- oder entladbar sind.

4. Vorrichtung nach einem der vorhergehenden Ansprüche, wobei zumindest eines der Trägerelemente (2, 3) als Haltemittel schlitzartige Ausnehmungen oder Zähne (5) aufweist.

5. Vorrichtung nach einem der vorhergehenden Ansprüche, wobei die Zähne (5) so auf dem Trägerelement (2, 3) angebracht sind, dass ein Zahngrund (18) der Zähne (5) auf der oberen Scheitellinie (17) des Trägerelements (2, 3) liegt.

6. Vorrichtung nach einem der vorhergehenden Ansprüche, wobei das Trägergegenelement (4) in Richtung des Trägerelements (2, 3) weisende als schlitzartige Ausnehmungen oder Zähne (5) ausgebildete Haltemittel aufweist.

7. Vorrichtung nach einem der vorhergehenden Ansprüche, wobei die Zähne (5) so auf dem Trägergegenelement (4) angebracht sind, dass ein Zahngrund (18) der Zähne (5) auf der unteren Scheitellinie (19) des Trägergegenelements (4) liegt.

8. Vorrichtung nach einem der vorhergehenden Ansprüche, wobei das Trägergegenelement (4) bezüglich des Trägerelements (2, 3) so angeordnet oder ausgebildet ist, dass die Substrate (S) bei einer Bewegung in die Vertikalrichtung (V) stets in den Haltemitteln (5) gehalten werden.

9. Vorrichtung nach einem der vorhergehenden Ansprüche, wobei das Trägerelement (2, 3) einen im Wesentlichen vertikal nach unten sich erstreckenden Ablaufsteg (7a) aufweist.

10. Vorrichtung nach einem der vorhergehenden Ansprüche, wobei das Trägergegenelement (4) einen im Wesentlichen vertikal nach oben sich erstreckenden weiteren Ablaufsteg (7b) aufweist.

11. Vorrichtung nach einem der vorhergehenden Ansprüche, wobei eine Breite des Ablaufstegs (7a) und/oder des weiteren Ablaufstegs (7b) zur Mitte des Trägerelements (2, 3) bzw. des Trägergegenelements (4) hin zunimmt.

12. Vorrichtung nach einem der vorhergehenden Ansprüche, wobei die Kanten (8, 10, 12) der Wände (1) abgeschrägt sind.

13. Vorrichtung nach einem der vorhergehenden Ansprüche, wobei die Unterkanten (8) der Wände (1) beiderseits einer mittig angeordneten U-förmigen ersten Ausnehmung (9) schräg abfallen.

14. Vorrichtung nach einem der vorhergehenden Ansprüche, wobei die Seitenkanten (10) in einem oberen Abschnitt in einander gegenüberliegenden Anordnung zweite Ausnehmungen (11) zum Eingriff einer Greifvorrichtung aufweisen.

15. Vorrichtung nach einem der vorhergehenden Ansprüche, wobei eine Oberkante (12) der Wände (1) eine dritte Ausnehmung (13) zum Eingreifen einer Be- bzw. Entladeeinrichtung für Substrate (S) aufweist.

16. Vorrichtung nach einem der vorhergehenden Ansprüche, wobei die dritte Ausnehmung (13) durch wenigstens zwei schräg zu den Seitenkanten (10) verlaufenden Ausnehmungskanten (14a, 14b) begrenzt ist.

17. Vorrichtung nach einem der vorhergehenden Ansprüche, wobei das Trägerelement (2, 3) und/oder das Trägergegenelement (4) aus einer, vorzugsweise mit einem ersten Kunststoff ummantelten, Versteifungsstruktur (15) gebildet sind.

18. Vorrichtung nach einem der vorhergehenden Ansprüche, wobei die Versteifungsstruktur (15) aus Metall, Glas, Keramik oder einem, vorzugsweise mit Fasern verstärkten, zweiten Kunststoff hergestellt ist.

19. Vorrichtung nach einem der vorhergehenden Ansprüche, wobei die Wände (1) aus dem ersten Kunststoff hergestellt sind.

20. Vorrichtung nach einem der vorhergehenden Ansprüche, wobei der erste Kunststoff ein gegen Säuren und Basen resistenter Kunststoff ist, der vorzugsweise aus der folgenden Gruppe ausgewählt ist: PFA, PTFE, PVDF.

21. Vorrichtung nach einem der vorhergehenden Ansprüche, wobei der erste Kunststoff mit Fasern verstärkt ist.

22. Vorrichtung nach einem der vorhergehenden Ansprüche, wobei vier Trägerelemente (2, 3) die Wände (1) verbinden.

23. Vorrichtung nach einem der vorhergehenden Ansprüche, wobei zwei untere Trägerelemente (2) in der Nähe einer Unterkante (8) der Wände (1) und zwei obere Trägerelemente (3) in der Nähe eines unteren Abschnitts der Seitenkanten (10) der Wände (1) angebracht sind.

24. Vorrichtung nach einem der vorhergehenden Ansprüche, wobei das Trägergegenelement (4) in der Nähe einer Oberkante (12) der Wände (1) angebracht ist.

25. Vorrichtung nach einem der vorhergehenden Ansprüche, wobei das Trägergegenelement (4) bezüglich einer die Anordnung oder Ausbildung des/der Trägerelements/Trägerelemente (2, 3) betreffenden und parallel zu dieser/diesen verlaufenden Symmetrieebene (E) versetzt angeordnet ist.

## Claims

1. Device for retaining substrates (S), in particular wafers or silicon substrates, for the production of photovoltaic elements with two walls (1) being opposite to each other,
wherein at least two rod-like carrier elements (2, 3) for connecting the walls (1) are provided,
wherein the carrier elements (2, 3) are provided for retaining substrates (S) supported thereon in a vertical position oriented parallel to the walls (1) with a retaining means (5),
**characterized in that**
at least one rod-like counter carrier element (4) connecting the two walls (1) is provided which is positioned in relation to the carrier elements (2, 3)
so that a vertical movement of the substrates (S) relative to the walls (1) is limited thereby and loading or unloading of the substrates (S) is possible at a slant in relation to the vertical direction (V).

2. Device as claimed in claim 1, wherein the counter carrier element (4) is mounted to the walls (1), preferably detachably.

3. Device as claimed in claim 1 or 2, wherein the substrates (S) can also be loaded or unloaded in the vertical direction (V) when the counter carrier element (4) is removed.

4. Device as claimed in any of the preceding claims, wherein at least one of the carrier elements (2, 3) has slit-type recesses or teeth (5) as retaining means.

5. Device as claimed in any of the preceding claims, wherein the teeth (5) are attached on the carrier element (2, 3) so that a tooth base (18) of the teeth (5) is located on the upper apex line (17) of the carrier element (2,3).

6. Device as claimed in any of the preceding claims, wherein the counter carrier element (4) has retaining means formed as slit-like recesses or teeth (5) pointing in the direction of the carrier element (2, 3).

7. Device as claimed in any of the preceding claims, wherein the teeth (5) are attached on the counter carrier element (4) so that a tooth base (18) of the teeth (5) is located on the lower apex line (19) of the counter carrier element (4).

8. Device as claimed in any of the preceding claims, wherein the counter carrier element (4) is positioned or formed in relation to the carrier element (2, 3) so that the substrates (S) are always retained in the retaining means when a movement in the vertical direction (V) occurs.

9. Device as claimed in any of the preceding claims, wherein the carrier element (2, 3) has a draining ridge (7a) which essentially runs vertically downwards.

10. Device as claimed in any of the preceding claims, wherein the counter carrier element (4) has an additional draining ridge (7b) which essentially runs vertically upwards.

11. Device as claimed in any of the preceding claims, wherein a width of the draining ridge (7a) and/or the additional draining ridge (7b) increases towards the middle of the carrier element (2, 3) or the counter carrier element (4).

12. Device as claimed in any of the preceding claims, wherein the edges (8, 10, 12) of the walls (1) are slanted.

13. Device as claimed in any of the preceding claims, wherein the lower edges (8) of the walls (1) slope downwards from both sides of a centric U-shaped first recess (9).

14. Device as claimed in any of the preceding claims, wherein the side edges (10) have second recesses (11) in an upper section in vis-à-vis arrangement for engagement of a gripping device.

15. Device as claimed in any of the preceding claims, wherein an upper edge (12) of the walls (1) has a third recess (13) for engagement of a loading or unloading device for substrates (S).

16. Device as claimed in any of the preceding claims, wherein the third recess (13) is limited by at least two recess edges (14a, 14b) running at a slant to the side edges (10).

17. Device as claimed in any of the preceding claims, wherein the carrier element (2, 3) and/or the counter carrier element (4) are formed from a stiffening structure (15), preferably with a first plastic coating.

18. Device as claimed in any of the preceding claims, wherein the stiffening structure (15) is made of metal, glass, ceramic or a second plastic, preferably reinforced with fibers.

19. Device as claimed in any of the preceding claims, wherein the walls (1) are made from the first plastic.

20. Device as claimed in any of the preceding claims, wherein the first plastic is a plastic which is resistant to acids and bases and which is preferably selected from the following group: PFA, PTFE, PVDF.

21. Device as claimed in any of the preceding claims, wherein the first plastic is reinforced with fibers.

22. Device as claimed in any of the preceding claims, wherein four carrier elements (2, 3) connect the walls (1).

23. Device as claimed in any of the preceding claims, wherein two lower carrier elements (2) are mounted in the vicinity of a lower edge (8) of the walls (1) and two upper carrier elements (3) are mounted in the vicinity of a lower section of the side edges (10) of the walls (1).

24. Device as claimed in any of the preceding claims, wherein the counter carrier element (4) is mounted in the vicinity of an upper edge (12) of the walls (1).

25. Device as claimed in any of the preceding claims, wherein the counter carrier element (4) is mounted staggered in relation to a symmetry plane (E) that relates to the arrangement or the formation of the carrier element/carrier elements (2, 3) and runs parallel to this/these.

## Revendications

1. Dispositif pour la réception de substrats (S), en particulier de wafers ou de substrats de silicium pour la fabrication d'éléments photovoltaiques, avec deux parois réciproquement opposées (1),
au moins deux éléments porteurs (2, 3) en forme de barre reliant les parois (1) étant prévus,
les éléments porteurs (2, 3) destinés au maintien, dans une position verticale, parallèle aux parois (1), des substrats (S) qui s'y appuient étant munis de moyens de support (5),
**caractérisé en ce qu'**
au moins un contre-élément porteur (4) en forme de barre reliant les deux parois (1) est prévu, lequel par rapport aux éléments porteurs (2, 3) est disposé
de façon qu'un mouvement vertical des substrats (S) soit limité relativement aux parois (1) et qu'un chargement ou déchargement des substrats (S) soit possible diagonalement par rapport au sens vertical (V).

2. Dispositif selon la revendication 1, le contre-élément porteur (4) étant fixé, de préférence de manière amovible, aux parois (1).

3. Dispositif selon la revendication 1 ou 2, les substrats (S), contre-élément porteur (4) retiré, pouvant être chargés ou déchargés aussi dans le sens vertical (V).

4. Dispositif selon l'une des revendications précédentes, au moins un des éléments porteurs (2, 3), faisant office de moyen de support, présentant des entailles en forme de fente ou des dents (5).

5. Dispositif selon l'une des revendications précédentes, les dents (5) étant disposées sur l'élément porteur (2, 3) de façon qu'un fond (18) des dents (5) soit sur la ligne des sommets supérieure (17) de l'élément porteur (2, 3).

6. Dispositif selon l'une des revendications précédentes, le contre-élément porteur (4) présentant dans la direction de l'élément porteur (2, 3) des moyens de support tels des entailles en forme de fente ou des dents (5).

7. Dispositif selon l'une des revendications précédentes, les dents (5) étant disposées sur le contre-élément porteur (4) de façon qu'un fond (18) des dents (5) soit sur la ligne des sommets inférieure (19) du contre-élément porteur (4).

8. Dispositif selon l'une des revendications précédentes, le contre-élément porteur (4) par rapport à l'élément porteur (2, 3) étant disposé ou étant tel que les substrats (S) soient toujours retenus dans les moyens de support (5) en cas de mouvement dans le sens vertical (V).

9. Dispositif selon l'une des revendications précédentes, l'élément porteur (2, 3) présentant une bride d'écoulement (7a) s'avançant essentiellement verticalement vers le bas.

10. Dispositif selon l'une des revendications précédentes, le contre-élément porteur (4) présentant une autre bride d'écoulement (7b) s'avançant essentiellement verticalement vers le haut.

11. Dispositif selon l'une des revendications précédentes, une largeur de la bride d'écoulement (7a) et/ou de l'autre bride d'écoulement (7b) s'agrandissant vers le milieu de l'élément porteur (2, 3) ou du contre-élément porteur (4).

12. Dispositif selon l'une des revendications précédentes, les arêtes (8, 10, 12) des parois (1) étant biseautées.

13. Dispositif selon l'une des revendications précédentes, les arêtes inférieures (8) des parois (1) s'inclinant de part et d'autre d'une première entaille (9) en forme de U disposée au centre.

14. Dispositif selon l'une des revendications précédentes, les arêtes latérales (10) présentant dans une section supérieure des deuxièmes entailles (11) réciproquement opposées pour l'enclenchement d'un dispositif de préhension.

15. Dispositif selon l'une des revendications précédentes, une arête supérieure (12) des parois (1) présentant une troisième entaille (13) pour l'enclenchement d'un dispositif de chargement ou de déchargement des substrats (S).

16. Dispositif selon l'une des revendications précédentes, la troisième entaille (13) étant limitée par au moins deux arêtes d'entailles (14a, 14b) obliques par rapport aux arêtes latérales (10).

17. Dispositif selon l'une des revendications précédentes, l'élément porteur (2, 3) et/ou le contre-élément porteur (4) consistant en une structure de renfort (15), de préférence gainée avec une matière plastique.

18. Dispositif selon l'une des revendications précédentes, la structure de renfort (15) étant en métal, en verre, en céramique ou en une deuxième matière plastique, de préférence renforcée par des fibres.

19. Dispositif selon l'une des revendications précédentes, les parois (1) étant fabriqués à partir de la première matière plastique.

20. Dispositif selon l'une des revendications précédentes, la première matière plastique étant une matière plastique résistante aux acides et aux bases, laquelle est de préférence sélectionnée à partir du groupe suivant : PFA, PTFE, PVDF.

21. Dispositif selon l'une des revendications précédentes, la première matière plastique étant renforcée par des fibres.

22. Dispositif selon l'une des revendications précédentes, quatre éléments porteurs (2, 3) reliant les parois (1).

23. Dispositif selon l'une des revendications précédentes, deux éléments porteurs inférieurs (2) étant disposés à proximité d'une arête inférieure (8) des parois (1) et deux éléments porteurs supérieurs (3) à proximité d'une section inférieure des arêtes latérales (10) des parois (1).

24. Dispositif selon l'une des revendications précédentes, le contre-élément porteur (4) étant disposé à proximité d'une arête supérieure (12) des parois (1).

25. Dispositif selon l'une des revendications précédentes, le contre-élément porteur (4) étant décalé par rapport à un plan de symétrie relatif à la disposition ou à la formation du/des élément(s) porteur(s) (2, 3) et parallèlement à ce/ces dernier(s).
